# EUROPEAN PATENT APPLICATION

(11) **EP 2 837 460 A2**
(43) Date of publication of application: **18.02.2015**
(21) Application number: 14162424.7
(22) Date of filing: 28.03.2014
(51) Int. Cl.: B23K 26/30

(54) **Laser irradiation apparatus**

(30) Priority: 31.07.2013 KR 20130091090
(71) Applicant: Samsung Display Co., Ltd., Gyeonggi-Do (KR)
(72) Inventor: Kim, Joon Hyung, Gyeonggi-do (KR); Lee, Hae Sook, Gyeonggi-do (KR); Kim, Sung Gon, Gyeonggi-do (KR); Jeong, Il Young, Gyeonggi-do (KR); Han, Gyoo Wan, Gyeonggi-do (KR); Ryu, Je Kil, Gyeonggi-do (KR); Cho, Kyoung Seok, Gyeonggi-do (KR)
(74) Representative: Mounteney, Simon James

(57) **Abstract**

A laser irradiation apparatus is provided. The laser irradiation apparatus includes a laser beam generator configured to generate laser beams; a slit unit configured to selectively transmit the laser beams; a mirror unit configured to change a path of the selectively transmitted laser beams, so as to irradiate the selectively transmitted laser beams onto a processing target; a first optical system, wherein a first portion of the selectively transmitted laser beams penetrates through the mirror unit and is projected to the first optical system; and a second optical system, wherein a second portion of the selectively transmitted laser beams penetrates through the mirror unit and is projected to the second optical system.

## Description

### BACKGROUND

### (a) Technical Field

The present invention relates to a laser irradiation apparatus.

### (b) Description of the Related Art

Thin film transistors are widely used as switching devices for liquid crystal displays (LCD) and organic light emitting diode (OLED) displays.

A thin film transistor typically includes a channel formed of a semiconductor material. The semiconductor material may include silicon. Silicon may be generally classified into amorphous silicon and crystalline silicon, depending on its crystalline state. The characteristics of amorphous silicon and crystalline silicon are briefly described below.

An advantage of amorphous silicon is that it may be deposited as a thin film at relatively low temperatures. However, amorphous silicon does not have a regular atomic arrangement and its grain size cannot be increased. As a result, amorphous silicon has relatively poor electrical characteristics.

Unlike amorphous silicon, the grain size of crystalline silicon can be increased which leads to improved electrical conductivity. Accordingly, the electrical characteristics of crystalline silicon may be improved relative to that of amorphous silicon. For example, the current flow in crystalline silicon may be improved more than 100 times compared to amorphous silicon.

As mentioned above, a thin film transistor typically includes a channel formed of a semiconductor material. Heat treatment may be performed on the semiconductor material, so as to modify the electrical and physical characteristics of the semiconductor material. For example, a semiconductor material comprising amorphous silicon can be crystalized to polysilicon using heat treatment.

An LCD or OLED display device typically includes an insulating substrate. The insulating substrate may be formed of a material having a low melting point (such as glass). In manufacturing the display device, an amorphous silicon thin film is deposited onto the insulating substrate. The amorphous silicon thin film is then subsequently changed into a crystalline silicon thin film using, for example, heat treatment.

The heat treatment may include directing a high energy laser beam (e.g. excimer laser) at the amorphous silicon thin film. The laser beam may be generated from a light source. The laser beam may penetrate a slit unit. The portion of the laser beam passing through the slit unit may be reflected by a mirror unit. The reflected laser beam may be irradiated onto a portion of the substrate where the amorphous silicon thin film is disposed.

In some instances, a profiler for detecting the laser beam may be provided. Specifically, the profiler may monitor a state of the laser beam irradiated onto the substrate. A conventional profiler can determine the state of the laser beam after the laser irradiation process is completed, or intermittently during the laser irradiation process.

However, the conventional profiler is generally incapable of determining and analyzing the state of the laser beam in real time. As a result, the conventional profiler may not be able to precisely determine the exact point at which a process defect or excursion occurs.

### SUMMARY

The present disclosure is directed to address at least the above issues relating to the real time monitoring of the state of laser beams in a laser irradiation apparatus.

According to some embodiments of the inventive concept, a laser irradiation apparatus is provided. The laser irradiation apparatus includes a laser beam generator configured to generate laser beams; a slit unit configured to selectively transmit the laser beams; a mirror unit configured to change a path of the selectively transmitted laser beams, so as to irradiate the selectively transmitted laser beams onto a processing target; a first optical system, wherein a first portion of the selectively transmitted laser beams penetrates through the mirror unit and is projected to the first optical system; and a second optical system, wherein a second portion of the selectively transmitted laser beams penetrates through the mirror unit and is projected to the second optical system.

In some embodiments, the first optical system may have a first focal length and the second optical system may have a second focal length.

In some embodiments, the first focal length may be configured such that the selectively transmitted laser beams located at the slit unit are projected to the first optical system, and wherein the second focal length may be configured such that the selectively transmitted laser beams irradiated onto and reflected from the processing target are projected to the second optical system.

In some embodiments, the laser irradiation apparatus may further include a first monitoring unit coupled to the first optical system, wherein the first monitoring unit is configured to acquire images of the first portion of the selectively transmitted laser beams; and a second monitoring unit coupled to the second optical system, wherein the second monitoring unit is configured to acquire images of the second portion of the selectively transmitted laser beams.

In some embodiments, each of the first optical system and the second optical system may include at least one lens selected from a group comprising concave lenses, convex lenses, and cylindrical lenses.

In some embodiments, at least one lens may be formed of fused silica.

In some embodiments, the laser irradiation apparatus may further include a first focus controller disposed at a front side of the first optical system, wherein the first focus controller is configured to control a focal length of the laser beams in the first optical system; a second focus controller disposed at a front side of the second optical system, wherein the second focus controller is configured to control a focal length of the laser beams in the second optical system; and a third focus controller disposed at a front side of the beam splitter, wherein the third focus controller is configured to control a focal length of the laser beams at the beam splitter.

In some embodiments, each of the first focus controller, second focus controller, and third focus controller may include a plurality of lenses.

In some embodiments, the laser irradiation apparatus may further include a beam splitter configured to split the first and second portions of the selectively transmitted laser beams penetrating through the mirror unit, such that the first portion is projected to the first optical system and the second portion is projected to the second optical system.

In some embodiments, the laser irradiation apparatus may further include an analysis unit configured to analyze images of the first and second portions of the selectively transmitted laser beams projected respectively to the first and second optical systems.

In some embodiments, the laser irradiation apparatus may further include a controller configured to control the laser beam generator based on the images analyzed by the analysis unit.

According to some other embodiments of the inventive concept, a method for monitoring laser beams of a laser irradiation apparatus, wherein the laser beams are generated by a laser beam generator, is provided. The method includes selectively transmitting the laser beams through a slit unit; changing a path of the selectively transmitted laser beams using a mirror unit, so as to irradiate the selectively transmitted laser beams onto a processing target; projecting a first portion of the selectively transmitted laser beams penetrating through the mirror unit to a first optical system; projecting a second portion of the selectively transmitted laser beams penetrating through the mirror unit to a second optical system; and acquiring images of the first and second portions of the selectively transmitted laser beams.

In some embodiments, the method may further include splitting, using a beam splitter, the first and second portions of the selectively transmitted laser beams penetrating through the mirror unit, such that the first portion is projected to the first optical system and the second portion is projected to the second optical system.

In some embodiments, acquiring the images of the first and second portions of the selectively transmitted laser beams may include acquiring, using a first monitoring unit, the images of the first portion of the selectively transmitted laser beams projected to the first optical system; and acquiring, using a second monitoring unit, the images of the second portion of the selectively transmitted laser beams projected to the second optical system.

In some embodiments, the first optical system may have a first focal length and the second optical system may have a second focal length.

In some embodiments, the first focal length may be configured such that the selectively transmitted laser beams located at the slit unit are projected to the first optical system, and wherein the second focal length may be configured such that the selectively transmitted laser beams irradiated onto and reflected from the processing target are projected to the second optical system.

In some embodiments, the images of the first portion of the selectively transmitted laser beams may include images of the selectively transmitted laser beams located at the slit unit, and the images of the second portion of the selectively transmitted laser beams may include images of the selectively transmitted laser beams irradiated onto and reflected from the processing target.

In some embodiments, the method may further include analyzing the images of the first and second portions of the selectively transmitted laser beams.

In some embodiments, analyzing the images of the first and second portions of the selectively transmitted laser beams may include comparing the images of the first and second portions of the selectively transmitted laser beams.

In some embodiments, the method may further include controlling the laser beam generator based on results of the comparison of the images of the first and second portions of the selectively transmitted laser beams.

At least some of the above and other features of the invention are set out in the claims.

### BRIEF DESCRIPTION OF THE DRAWINGS

FIG. 1 is a schematic diagram of a laser irradiation apparatus according to an embodiment of the inventive concept.
FIG. 2 illustrates laser beams passing through a slit unit according to an embodiment of the invention.
FIG. 3 illustrates the monitoring of laser beams using a first optical system and a second optical system according to an embodiment of the invention.
FIG. 4 is a schematic diagram illustrating an exemplary configuration of the first optical system of FIG. 3.
FIG. 5 is a schematic diagram illustrating an exemplary configuration of the second optical system of FIG. 3.
FIG. 6 is a schematic diagram of a laser irradiation apparatus according to another embodiment of the inventive concept.
FIG. 7 is a flowchart of a method of monitoring laser beams according to an embodiment of the invention.
FIGs. 8 and 9 are detailed flowcharts further describing Step S300 of FIG. 7.

### DETAILED DESCRIPTION

The present inventive concept will be described more fully herein with reference to the accompanying drawings, in which embodiments of the inventive concept are shown. As those skilled in the art would realize, the embodiments may be modified in various ways without departing from the scope of the inventive concept. The drawings and description are intended to be illustrative in nature and should not be construed as limiting the inventive concept. Like reference numerals designate like elements throughout the specification.

It should be noted that the size and thickness of the elements in each configuration in the drawings may have been exaggerated for further clarity.

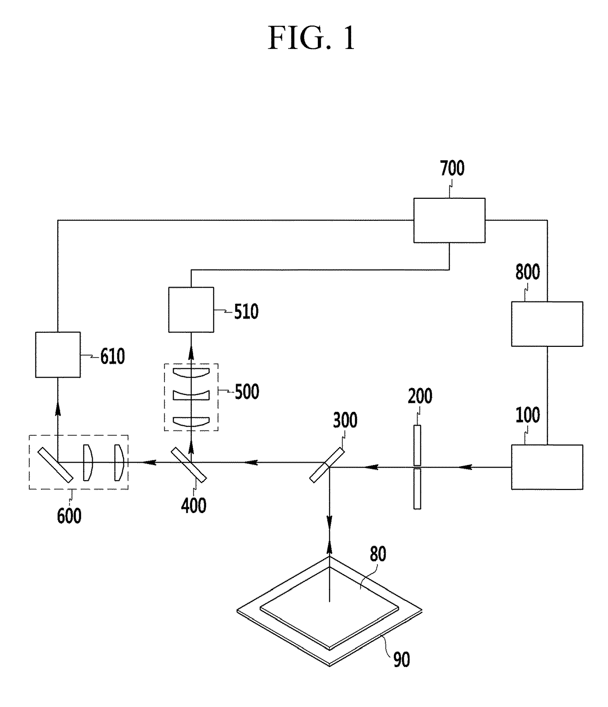

FIG. 1 is a schematic diagram of a laser irradiation apparatus according to an embodiment of the inventive concept. Referring to FIG. 1, the laser irradiation apparatus includes a laser beam generator 100, a slit unit 200, a mirror unit 300, and a beam splitter 400. The laser irradiation apparatus further includes a first optical system 600 and a second optical system 500. (Not shown).

The laser beam generator 100 generates laser beams. The laser beams may be used to crystallize an amorphous silicon thin film (not shown) disposed on a substrate 80. The substrate 80 may be referred to as a processing target. The wavelength, amplitude, and energy density of the laser beams may be controlled through the laser beam generator 100. Accordingly, the laser beam generator 100 can be configured to generate laser beams having appropriate parameters for successful crystallization of the amorphous silicon thin film.

In addition, the laser beam generator 100 can dynamically control a direction of the laser beams. In the example of FIG. 1, the laser beam generator 100 directs the laser beams toward the slit unit 200. However, if the direction of the laser beams changes due to vibration or other external influences, the laser beam generator 100 can move the laser beams back to its original direction (toward the slit unit 200), as described later in the specification.

The laser beam generator 100 may include laser beam generators known to those of ordinary skill in the art. For example, the laser beam generator 100 may include an excimer laser irradiation apparatus.

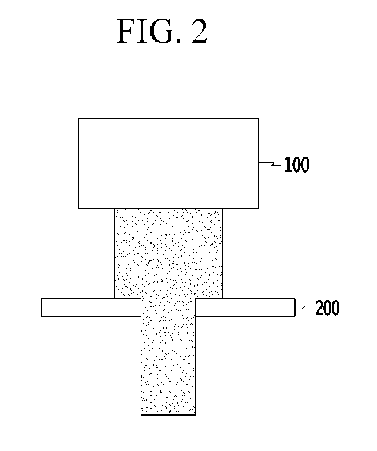

As shown in FIG. 2, the slit unit 200 selectively transmits a portion of the laser beams irradiated from the laser beam generator 100. For example, an opening may be formed in the slit unit 200 to allow the portion of the laser beams to be selectively transmitted. Accordingly, the width of the transmitted laser beams may be controlled by modifying the size of the opening in the slit unit 200.

Referring to FIG. 1, the mirror unit 300 changes the direction of the laser beams passing through the slit unit 200. Specifically, the mirror unit 300 changes the direction of the laser beams so as to direct the laser beams toward the processing target (i.e., substrate 80).

In the example of FIG. 1, the mirror unit 300 controls the direction of the laser beams by changing a reflection angle of the laser beams. As shown in FIG. 1, the laser beams passing through the slit unit 200 are reflected by the mirror unit 300, and subsequently directed toward the substrate 80.

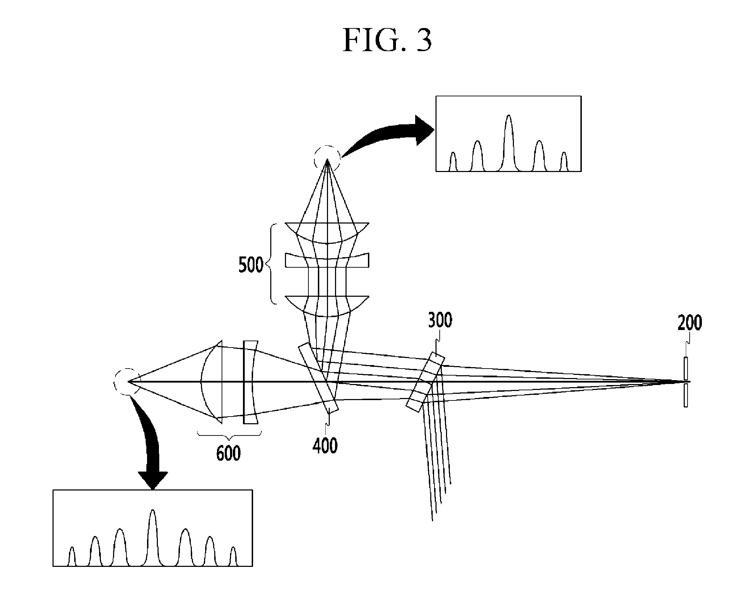

In this embodiment, the mirror unit 300 has a reflection rate of about 99% (i.e., not all the laser beams are reflected). Accordingly, a portion of the laser beams impinging onto the mirror unit 300 may partially penetrate the mirror unit 300. Referring to FIG. 3, the portion of the laser beams penetrating the mirror unit 300 includes: (1) the laser beams passing through the slit unit 200; and (2) the laser beams irradiated onto (and reflected) from the substrate 80 back to the mirror unit 300.

The state of the laser beams can be monitored using the portion of the laser beams penetrating the mirror unit 300. For example, (1) a state of the laser beams passing through the slit unit 200, and/or (2) a state of the laser beams irradiated onto (and reflected from) the substrate 80, can be monitored, as described later in the specification.

Referring to FIG. 3, the laser beams passing through the slit unit 200 may be focused in the first optical system 600. The laser beams irradiated onto (and reflected) from the substrate 80 back to the mirror unit 300 may be focused in the second optical system 500. The projection of the aforementioned laser beams may be achieved using the configuration illustrated in FIG. 3.

Referring to FIG. 3, the laser beams located at the slit unit 200 are disposed away from the first optical system 600 (for example, by a first distance). Likewise, the laser beams irradiated onto (and reflected from) the substrate 80 are disposed away from the second optical system 500 (for example, by a second distance).

In an embodiment, a state of the laser beams passing through the slit unit 200, and also a state of the laser beams irradiated onto (and reflected from) the substrate 80, can be observed in real time at locations disposed away from the slit unit 200 and the substrate 80.

Referring to FIGs. 1 and 3, the laser beams from the slit unit 200 penetrate the mirror unit 300 and are subsequently split by the beam splitter 400. The split laser beams (from the slit unit 200) are then projected to the first optical system 600. The first optical system 600 has a first focal length that allows the split laser beams (from the slit unit 200) to be projected to the first optical system 600.

Likewise, the laser beams irradiated onto (and reflected from) the substrate 80 penetrate the mirror unit 300 and are subsequently split by the beam splitter 400. The split laser beams (from the substrate 80) may be projected to the second optical system 500. The second optical system 500 has a second focal length that allows the split laser beams (from the substrate 80) to be projected to the second optical system 500.

The laser beams from the slit unit 200 and substrate 80 may be projected to the first optical system 600 and the second optical system 500, respectively, by controlling the first and second focal lengths.

Here, the laser beams from the slit unit 200 being focused in the first optical system 600 works on the same principle as observing a far away object using a camera by controlling the focal length of a zoom lens in the camera.

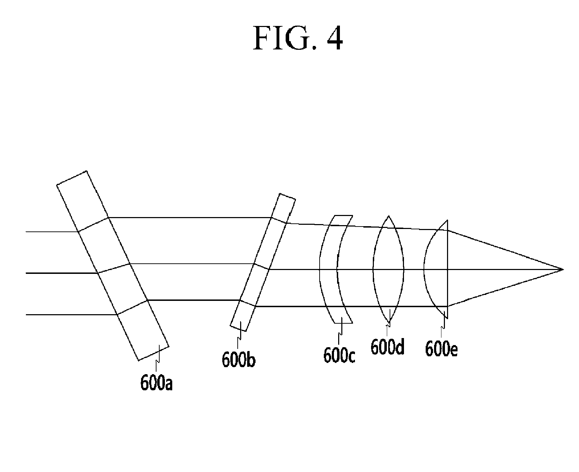

FIG. 4 is a schematic diagram illustrating an exemple configuration of the first optical system 600 of FIG. 3.

Referring to FIG. 4, the first optical system 600 may include a plurality of lenses. The plurality of lenses may include convex lenses, concave lenses, or cylindrical lenses. In some embodiments, the first optical system 600 may include at least one lens selected from a group comprising concave lenses, convex lenses, and cylindrical lenses.

The convex lenses may include symmetrical double convex lenses, asymmetrical double convex lenses, plano-convex lenses, or positive meniscus lenses.

The concave lenses may include symmetrical biconcave lenses, asymmetrical biconcave lenses, plano-concave lenses, or negative meniscus lenses.

The first optical system 600 may include any combination of the lenses mentioned above. For example, as shown in FIG. 4, the first optical system 600 may include cylindrical lenses 600a and 600b, negative meniscus lens 600c, symmetrical double convex lens 600d, and plano-convex lens 600e.

The cylindrical lenses 600a and 600b, negative meniscus lens 600c, symmetrical double convex lens 600d, and plano-convex lens 600e may be sequentially arranged in the first optical system 600. Also, as shown in FIG. 4, the lenses in the first optical system 600 may have different radii, thicknesses, focal lengths, etc.

It should be noted that the type and order of lenses in the first optical system 600 need not be limited to the embodiment illustrated in FIG. 4. One of ordinary skill in the art would readily appreciate that various types of lenses may be arranged in different configurations in other embodiments.

The lenses in the first optical system 600 are configured such that the first optical system 600 has a focal length (corresponding to the first focal length) for observing the laser beams located at the slit unit 200.

The lenses in the first optical system 600 may be formed of fused silica. Fused silica includes amorphous silica that is highly resistive to thermal shock, and is appropriate for transmitting high-temperature laser beams. Nevertheless, the material of the lens is not limited to fused silica. For example, other types of materials capable of resisting high temperature can be used to form the optical lenses.

As mentioned above, in the described embodiment, the laser beams located at the slit unit 200 are projected to the first optical system 600. Nevertheless, in some embodiments, other laser beams (generated by the laser irradiation apparatus), in addition to the laser beams located at the slit unit 200, may be projected to the first optical system 600.

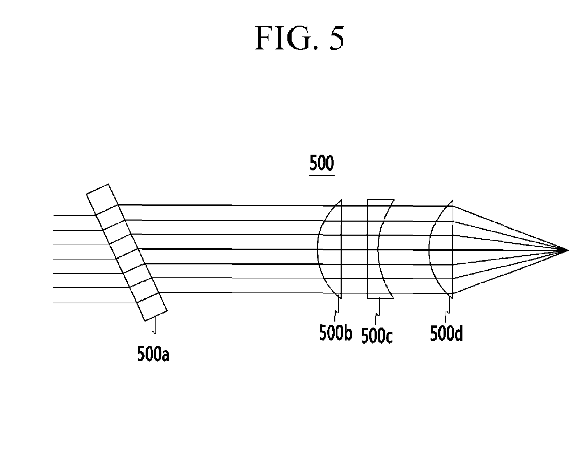

FIG. 5 is a schematic diagram illustrating an exemple configuration of the second optical system 500 of FIG. 3.

Referring to FIG. 5, the second optical system 500 may include a plurality of lenses. The plurality of lenses may include convex lenses, concave lenses, or cylindrical lenses. In some embodiments, the second optical system 500 may include at least one lens selected from a group comprising concave lenses, convex lenses, and cylindrical lenses.

The convex lenses may include symmetrical double convex lenses, asymmetrical double convex lenses, plano-convex lenses, or positive meniscus lenses.

The concave lenses may include symmetrical biconcave lenses, asymmetrical biconcave lenses, piano-concave lenses, or negative meniscus lenses.

The second optical system 500 may include any combination of the lenses mentioned above. For example, as shown in FIG. 5, the second optical system 500 may include cylindrical lens 500a, plano-convex lens 500b, plano-concave lens 500c, and plano-convex lens 500d.

The cylindrical lens 500a, plano-convex lens 500b, piano concave lens 500c, and plano-convex lens 500d may be sequentially arranged in the second optical system 500. As shown in FIG. 5, the lenses in the second optical system 500 may have different radii, thicknesses, focal lengths, etc.

It should be noted that the type and order of lenses in the second optical system 500 need not be limited to the embodiment illustrated in FIG. 5. One of ordinary skill in the art would readily appreciate that various types of lenses may be arranged in different configurations in other embodiments.

The lenses in the second optical system 500 are configured such that the second optical system 500 has a focal length (corresponding to the second focal length) for observing the laser beams irradiated onto (and reflected from) the substrate 80.

The lenses in the second optical system 500 may be formed of fused silica. Fused silica includes amorphous silica that is highly resistive to thermal shock, and is appropriate for transmitting high-temperature laser beams. Nevertheless, the material of the lens is not limited to fused silica. For example, other types of materials capable of resisting high temperature can be used to form the optical lenses.

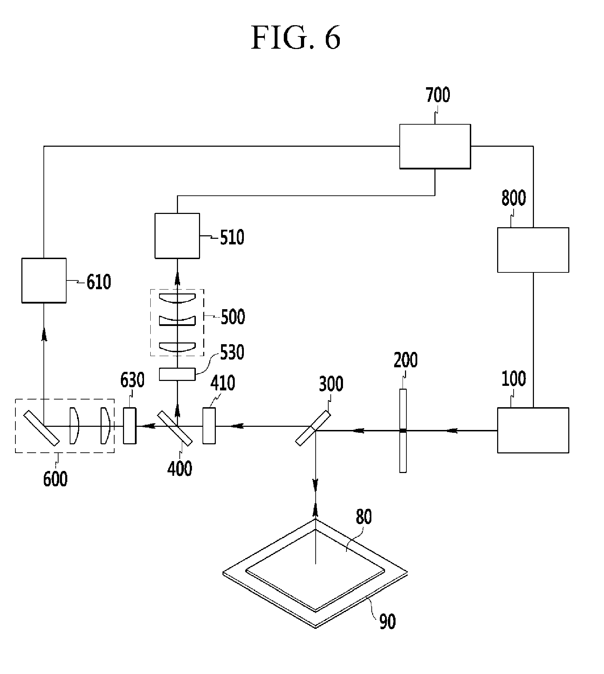

FIG. 6 is a schematic diagram of a laser irradiation apparatus according to another embodiment of the inventive concept.

The laser irradiation apparatus in FIG. 6 includes the elements described in FIGs. 1 and 3. Referring to FIG. 6, the laser irradiation apparatus further includes a first monitoring unit 610, a second monitoring unit 510, an analysis unit 700, a controller 800, a first focus controller 630, a second focus controller 530, and a third focus controller 410.

The first monitoring unit 610 is coupled to the first optical system 600. The first monitoring unit 610 is configured to monitor the laser beams (from the slit unit 200) that are projected to the first optical system 600.

The first monitoring unit 610 may acquire and store images of the laser beams. For example, the first monitoring unit 610 may acquire an image of the laser beams projected to the first optical system 600. As mentioned previously, the laser beams from the slit unit 200 are projected to the first optical system 600. Thus, the first monitoring unit 610 can acquire an image of the laser beams located at the slit unit 200, even though the first monitoring unit 610 and the first optical system 600 are disposed away from the slit unit 200.

The first monitoring unit 610 may acquire in real time images of the laser beams projected to the first optical system 600. For example, the first monitoring unit 610 can acquire images of the laser beams at predetermined time intervals. The time intervals may be modified accordingly so as to control an observation cycle of the first monitoring unit 610.

The first monitoring unit 610 may include camera devices known to one of ordinary skill in the art. For example, the first monitoring unit 610 may include a charge coupled device (CCD) camera.

The second monitoring unit 510 is coupled to the second optical system 500. The second monitoring unit 510 is configured to monitor the laser beams (from the substrate 80) that are projected to the second optical system 500.

The second monitoring unit 510 may acquire and store images of the laser beams. For example, the second monitoring unit 510 may acquire an image of the laser beams projected to the second optical system 500. As mentioned previously, the laser beams irradiated onto (and reflected) from the substrate 80 are projected to the second optical system 500. Thus, the second monitoring unit 510 can acquire an image of the laser beams located at the substrate 80, even though the second monitoring unit 510 and the second optical system 500 are disposed away from the substrate 80.

The second monitoring unit 510 may acquire in real time images of the laser beams projected to the second optical system 500. For example, the second monitoring unit 510 can acquire images of the laser beams at predetermined time intervals. The time intervals may be modified accordingly so as to control an observation cycle of the second monitoring unit 510.

The second monitoring unit 510 may include camera devices known to one of ordinary skill in the art. For example, the second monitoring unit 510 may include a charge coupled device (CCD) camera.

Referring to FIG. 6, the analysis unit 700 is coupled to the first monitoring unit 610 and the second monitoring unit 510. The analysis unit 700 is configured to analyze the images of the laser beams acquired by the first and second monitoring units 610 and 510, and to determine a state of the laser beams based on the images. For example, the analysis unit 700 may be configured to analyze the wavelength, amplitude, uniformity, and/or other parameters of the laser beams. Additionally, in some embodiments, the analysis unit 700 may analyze the damage degree of the lenses in the first optical system 600 and the second optical system 500.

As mentioned previously, the images of the laser beams acquired by the first monitoring unit 610 include images of the laser beams at the slit unit 200. The images of the laser beams acquired by the second monitoring unit 510 include images of the laser beams irradiated onto (and reflected from) the substrate 80. Thus, the analysis unit 700 can analyze the states of the laser beams located respectively at the slit unit 200 and the substrate 80. By analyzing the states of the laser beams, the analysis unit 700 can determine in real time whether there has been any change in the laser beams (e.g. a change in direction of the laser beams) generated from the laser beam generator 100.

In some embodiments, the analysis unit 700 can analyze and compare images of the laser beams acquired by the first monitoring unit 610 and the second monitoring unit 510. Thus, the analysis unit 700 can analyze and compare the states of the laser beams located at the slit unit 200 and the substrate 80. For example, the analysis unit 700 may analyze and compare the wavelength, amplitude, and/or uniformity of each of the laser beams. By analyzing and comparing the states of the laser beams, the analysis unit 700 can determine in real time whether a state of the laser beams irradiated onto the substrate 80 has changed. As a result, the analysis unit 700 can determine whether the laser beams irradiated onto the substrate 80 conform with desired specifications.

Referring to FIG. 6, the controller 800 is coupled to the analysis unit 700 and the laser beam generator 100. The controller 800 is configured to control the laser beam generator 100 using the analysis results from the analysis unit 700. For example, if the analysis results indicate that the laser beams have shifted, the controller 800 can control the laser beam generator 100 to rectify the shift in the laser beams.

In addition, the controller 800 can control the laser beam generator 100 to adjust the wavelength, amplitude, and/or other parameters of the laser beams.

In some embodiments, the controller 800 can generate an alarm that indicates a state of the laser beams. For example, when abnormal laser beams (i.e. laser beams not conforming with the desired specifications) are irradiated onto the substrate 80, the controller 800 may generate an alarm warning of the abnormal state of the laser beams.

In some further embodiments, if the analysis results from the analysis unit 700 indicate that an impurity exists in the laser beam generator 100, the controller 800 may generate an alarm alerting of the need to clean the laser beam generator 100.

The controller 800 is further configured to control the first to third focus controllers 630, 530, and 410. Specifically, the controller 800 may be configured to automatically control a focal length of each of the focus controllers 630, 530, and 410.

The first focus controller 630 is coupled to the first optical system 600. As shown in FIG. 6, the first focus controller 630 may be provided at a front side of the first optical system 600. The front side of the first optical system 600 corresponds to the side at which the laser beams are projected to the first optical system 600.

The first focus controller 630 includes a plurality of lenses. The plurality of lenses in the first focus controller 630 may be formed of a material capable of withstanding high-temperature laser beams. For example, the plurality of lenses may be formed of fused silica.

The first focus controller 630 includes a focal length. The focal length of the first focus controller 630 may be variable. The focal length of the first focus controller 630 can be controlled automatically or manually. Here, "automatically" means that the focal length of the first focus controller 630 is controlled by the controller 800, whereas "manually" means that the focal length of the first focus controller 630 is controlled by an operator. The focal length of the first focus controller 630 can be controlled in a manner similar to that of controlling a focal length of a zoom lens used in a photographing camera.

In the example of FIG. 6, the locations of the plurality of lenses of the first optical system 600 are fixed. As a result, the focal length of the first optical system 600 in FIG. 6 cannot be easily changed. However, the focal length of the first focus controller 630 is variable. Accordingly, by coupling the first focus controller 630 to the front side of the first optical system 600, the focal length of the first optical system 600 may be easily modified.

In some embodiments, a state of the laser beams in another location of the laser irradiation apparatus can be determined by controlling the focal length of the first optical system 600 using the first focus controller 630.

The second focus controller 530 is coupled to the second optical system 500. As shown in FIG. 6, the second focus controller 530 may be provided at a front side of the second optical system 500. The front side of the second optical system 530 corresponds to the side at which the laser beams are projected to the second optical system 500.

The second focus controller 530 may include a plurality of lenses. The plurality of lenses in the second focus controller 530 may be formed of a material capable of withstanding high-temperature laser beams. For example, the plurality of lenses may be formed of fused silica.

The second focus controller 530 includes a focal length. The focal length of the second focus controller 530 may be variable. The focal length of the second focus controller 530 can be controlled automatically or manually. Here, "automatically" means that the focal length of the second focus controller 530 is controlled by the controller 800, whereas "manually" means that the focal length of the second focus controller 530 is controlled by an operator. The focal length of the second focus controller 530 can be controlled in a manner similar to that of controlling a focal length of a zoom lens used in a photographing camera.

The third focus controller 410 is coupled to the beam splitter 400. As shown in FIG. 6, the third focus controller 410 may be provided at a front side of the beam splitter 400. The front side of the beam splitter 400 corresponds to the side at which the laser beams from the mirror unit 300 penetrate the beam splitter 400.

The third focus controller 410 may include a plurality of lenses. The plurality of lenses in the third focus controller 410 may be formed of a material capable of withstanding high-temperature laser beams. For example, the plurality of lenses may be formed of fused silica.

The third focus controller 410 includes a focal length. The focal length of the second focus controller 530 may be variable. The focal length of the third focus controller 410 can be controlled automatically or manually. Here, "automatically" means that the focal length of the third focus controller 410 is controlled by the controller 800, whereas "manually" means that the focal length of the third focus controller 410 is controlled by an operator. The focal length of the third focus controller 410 can be controlled in a manner similar to that of controlling a focal length of a zoom lens used in a photographing camera.

In the example of FIG. 6, the focal length of the third focus controller 410 can be controlled, so as to enable laser beams at a different location to be projected to the first optical system 600 and/or second optical system 500. That is, the third focus controller 410 enables laser beams from a different location (other than the slit unit 200 or the substrate 80) to be projected to the first optical system 600 and/or second optical system 500.

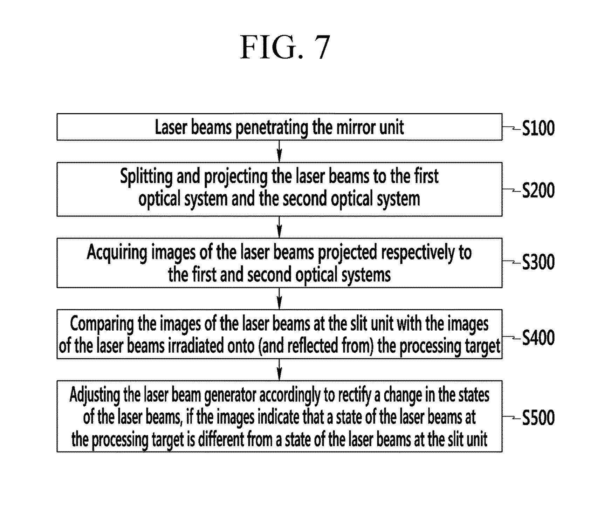

FIG. 7 is a flowchart of a method of monitoring laser beams using the laser irradiation apparatus of FIG. 6.

As described previously with reference to FIG. 1, laser beams are generated by the laser beam generator 100 and selectively transmitted through the slit unit 200. The path of the laser beams is changed by the mirror unit 300, such that the laser beams are irradiated onto a processing target. The processing target may correspond to the substrate 80 illustrated in FIG. 1. A portion of the laser beams irradiated onto the processing target are reflected from the processing target.

In this embodiment, the mirror unit 300 has a reflection rate of about 99% (i.e., not all the laser beams are reflected). Accordingly, in this embodiment, a portion of the laser beams impinging onto the mirror unit 300 may penetrate the mirror unit 300 (step S100). Referring back to FIG. 3, the portion of the laser beams penetrating the mirror unit 300 includes: (1) the laser beams passing through the slit unit 200; and (2) the laser beams irradiated onto (and reflected from) the substrate 80 back to the mirror unit 300.

Next, the laser beams penetrating through the mirror unit 300 are split by the beam splitter 400. The beam splitter 400 splits and projects the laser beams to the first optical system 600 and the second optical system 500 (step S200). Specifically, the laser beams at the slit unit 200 are projected to the first optical system 600, and the laser beams irradiated onto (and reflected from) the processing target are projected to the second optical system 500.

Next, images of the laser beams projected respectively to the first and second optical systems 600 and 500 are acquired (step S300). The images of the laser beams at the slit unit 200 are then compared with the images of the laser beams irradiated onto (and reflected from) the processing target (step S400). If the images indicate that a state of the laser beams at the processing target is different from a state of the laser beams at the slit unit 200, the laser beam generator 100 will be adjusted accordingly so as to rectify the change in the states of the laser beams (step S500).

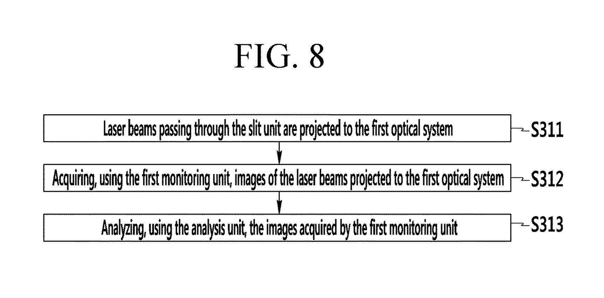

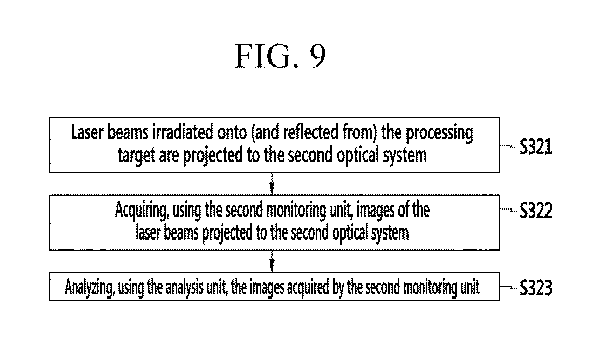

FIGs. 8 and 9 are detailed flowcharts further describing Step S300 of FIG. 7. Specifically, FIG. 8 describes the acquisition of images of the laser beams at the slit unit 200 that are projected to the first optical system 600, and FIG. 9 describes the acquisition of images of the laser beams at the processing target that are projected to the second optical system 500.

Referring to FIG. 8, the laser beams passing through the slit unit 200 are projected to the first optical system 600 after penetrating the mirror unit 300 (step S311). As mentioned previously, the first optical system 600 has a first focal length allowing the laser beams at the slit unit 200 to be focused by the first optical system 600.

Next, images of the laser beams projected to the first optical system 600 are acquired using the first monitoring unit 610 (step S312). The acquired images correspond to the images of the laser beams at the slit unit 200. The first monitoring unit 610 may include a CCD camera.

Next, the images of the laser beams acquired by the first monitoring unit 610 are analyzed using the analysis unit 700 (step S313). The analysis unit 700 can determine a state of the laser beams at the slit unit 200 based on the acquired images. For example, the analysis unit 700 can determine the wavelength, amplitude, uniformity, and/or other parameters of the laser beams at the slit unit 200.

Referring to FIG. 9, the laser beams irradiated onto (and reflected from) the processing target are projected to the second optical system 500 after penetrating the mirror unit 300 (step S321). As mentioned previously, the second optical system 500 has a second focal length allowing the laser beams irradiated onto (and reflected from) the processing target to be focused by the second optical system 500.

Next, images of the laser beams projected to the second optical system 500 are acquired using the second monitoring unit 510 (step S322). The acquired images correspond to the images of the laser beams irradiated onto (and reflected from) the processing target. The second monitoring unit 510 may include a CCD camera.

Next, the images of the laser beams acquired by the second monitoring unit 510 are analyzed using the analysis unit 700 (step S323). The analysis unit 700 can determine a state of the laser beams irradiated onto (and reflected from) the processing target based on the acquired images. For example, the analysis unit 700 can determine the wavelength, amplitude, uniformity, and/or other parameters of the laser beams at the processing target.

Referring back to FIGs. 7 to 9, after the images of the laser beams projected to the first and second optical systems 600 and 500 are acquired (step S300), the images of the laser beams at the slit unit 200 are compared with the images of the laser beams irradiated onto (and reflected from) the processing target (step S400). Specifically, the analysis unit 700 compares the wavelengths, amplitudes, and uniformity of the laser beams at the slit unit 200 and at the processing target. By analyzing and comparing the states of the laser beams, the analysis unit 700 can determine in real time whether a state of the laser beams irradiated onto the substrate 80 has changed. As a result, the analysis unit 700 can determine whether the laser beams irradiated onto the substrate 80 conform with the desired specifications.

As previously described, the controller 800 is coupled to the analysis unit 700 and laser beam generator 100. The controller 800 is configured to control the laser beam generator 100 using the analysis results from the analysis unit 700. For example, if the analysis results show that the laser beams have shifted, the controller 800 can control the laser beam generator 100 to rectify the shift in the laser beams. The controller 800 can also control the laser beam generator 100 such that the states of the laser beams at the slit unit 200 and the processing target are the same.

In addition, the controller 800 can control the laser beam generator 100 to adjust the wavelength, amplitude, and/or other parameters of the laser beams.

In some embodiments, the controller 800 can generate an alarm that indicates a state of the laser beams. For example, when abnormal laser beams are irradiated onto the substrate 80, the controller 800 may generate an alarm warning of the abnormal state of the laser beams.

In some further embodiments, if the analysis results from the analysis unit 700 indicate that an impurity exists in the laser beam generator 100, the controller 800 may generate an alarm alerting of the need to clean the laser beam generator 100.

Accordingly, using the above-described laser irradiation apparatus and method for monitoring laser beams, the laser beams located at a slit unit and/or a processing target can be observed in real time.

While this inventive concept has been described in connection with what are presently considered to be embodiments of the invention, it is to be understood that the inventive concept is not limited to the disclosed embodiments, but, on the contrary, is intended to cover various modifications and equivalent arrangements included within the scope of the present disclosure.

## Claims

1. A laser irradiation apparatus comprising:
a laser beam generator configured to generate laser beams;
a mirror unit configured to change a path of a first portion of the laser beams, so as to irradiate the first portion of the laser beams onto a processing target and transmit a second portion of the laser beams;
a first optical system, configured to receive the said first portion of the laser beams transmitted via the mirror unit and focus a first laser image in the first optical system; and
a second optical system, configured to receive a second portion of the laser beams transmitted via the mirror unit and focus a second laser image in the second optical system.

2. A laser irradiation apparatus accoding to Claim 1, further comprising a slit unit configured to selectively transmit the laser beams.

3. A laser irradiation apparatus according to claim 1 or 2, wherein the first optical system has a first focal length and the second optical system has a second focal length.

4. A laser irradiation apparatus according to any preceding claim, wherein the first focal length is configured such that laser beams located at a first location of the laser irradiation apparatus are focused in the first optical system, and wherein the second focal length is configured such that the laser beams located at a second location of the laser irradiation apparatus are focused in the second optical system.

5. A laser irradiation apparatus according to claim 4 when dependent on claim 2, wherein the first location is at the slit unit.

6. A laser irradiation apparatus according to claim 4 or 5, wherein the second location is at the procesing target.

7. A laser irradiation apparatus according to any preceding claim, further comprising:
a first monitoring unit coupled to the first optical system, wherein the first monitoring unit is configured to acquire images of the first portion of the laser beams; and
a second monitoring unit coupled to the second optical system, wherein the second monitoring unit is configured to acquire images of the second portion of the laser beams.

8. A laser irradiation apparatus according to any preceding claim, wherein each of the first optical system and the second optical system includes at least one lens selected from a group comprising concave lenses, convex lenses, and cylindrical lenses, and wherein the at least one lens is formed of fused silica.

9. A laser irradiation apparatus according to any preceding claim, further comprising a beam splitter configured to split the first and second portions of the selectively transmitted laser beams penetrating through the mirror unit, such that the first portion is projected to the first optical system and the second portion is projected to the second optical system.

10. A laser irradiation apparatus according to claim 9, further comprising:
a first focus controller disposed at a front side of the first optical system, wherein the first focus controller is configured to control the first focal;
a second focus controller disposed at a front side of the second optical system, wherein the second focus controller is configured to control the second focal length; and
a third focus controller disposed at a front side of the beam splitter, wherein the third focus controller is configured to control a focal length of the laser beams at the beam splitter.

11. A laser irradiation apparatus according to claim 10, wherein each of the first focus controller, second focus controller, and third focus controller includes a plurality of lenses.

12. A laser irradiation apparatus according to any preceding claim, further comprising an analysis unit configured to analyze images of the first and second portions of the laser beams projected respectively onto the first and second optical systems.

13. A laser irradiation apparatus according to claim 12, further comprising a controller configured to control the laser beam generator based on the images analyzed by the analysis unit.
